# EUROPÄISCHE PATENTSCHRIFT

(11) **EP 3 693 797 B1**
(45) Veröffentlichungstag und Bekanntmachung des Hinweises auf die Patenterteilung: **29.09.2021**
(21) Anmeldenummer: 20151766.1
(22) Anmeldetag: 14.01.2020
(51) Int. Cl.: G03F 7/20, B29C 64/135, B29C 64/25, B33Y 30/00

(54) **SYSTEM ZUM AUFBAU EINER LASERLITHOGRAFIEVORRICHTUNG UND MODULTRÄGER HIERFÜR**
SYSTEM FOR CONSTRUCTING A LASER LITHOGRAPHY DEVICE AND MODULE SUPPORT THEREFOR
SYSTÈME DE MONTAGE D'UN DISPOSITIF DE LITHOGRAPHIQUE LASER ET SUPPORT DE MODULE ASSOCIÉ

(30) Priorität: 29.01.2019 DE 102019102215
(43) Veröffentlichungstag der Anmeldung: 12.08.2020
(73) Patentinhaber: Nanoscribe Holding GmbH, 76344 Eggenstein-Leopoldshafen (DE)
(72) Erfinder: Linden, Christoph, 76275 Ettlingen (DE); Schach, Christian, 76137 Karlsruhe (DE); Sauter, Thomas, 69151 Neckargemünd (DE); Hoffmann, Jörg, 67363 Lustadt (DE)
(74) Vertreter: DREISS Patentanwälte PartG mbB

(56) Entgegenhaltungen:
- EP-A1- 1 975 980
- WO-A1-2010/044268
- US-A1- 2012 287 411
- US-A1- 2014 043 676

## Beschreibung

Die Erfindung betrifft das technische Feld der Laserlithografievorrichtungen, insbesondere für direktes Laserschreiben (auch als direct-laser-riting oder Laser-Scanning-Lithografie bezeichnet), wie es beispielsweise in der DE 10 2007 055 530 A1 beschrieben ist.

Bei der Technik der Laserlithografie werden Strukturen mittels eines Schreibstrahls in einem Lithografiematerial geschrieben. Das Lithografiematerial ist im Allgemeinen eine fotosensitive Substanz, deren Materialeigenschaften durch Einstrahlung von Licht verändert werden kann. Je nach Ausgestaltung kann das Lithografiematerial zunächst flüssig vorliegen (Lithografiefluid, flüssiger Fotolack). Das Lithografiematerial kann aber auch zunächst hochviskos oder fest vorliegen, z.B. als Lackschicht auf einem Substrat. Durch die Laserstrahlung des Schreibstrahls wird in Lithografiematerial lokal eine Materialveränderung (z.B. Verfestigungseffekt) ausgelöst. Die Materialveränderung erfolgt dabei beispielsweise aufgrund einer durch Photonen-Absorption induzierten, lokalen Polymerisation des Lithografiematerials. Eine entsprechende Technik unter Ausnutzung des physikalischen Prinzips der Zwei-Photonen-Polymerisation oder allgemein der Multi-Photonen-Polymerisation ist beispielsweise in der DE 101 11 422 A1 beschrieben.

Um dreidimensional ausgedehnte Strukturen zu erzeugen, wird der Schreibstrahl relativ zu Lithografiematerial bewegt oder Lithografiematerial wird relativ zu dem Schreibstrahl bewegt. Die relative Bewegung kann beispielsweise durch Auslenkung des Schreibstrahls mittels einer optomechanischen Einrichtung (z.B. Galvometer) und/oder durch Verlagerung des Lithografiematerials bzw. eines des Lithografiematerials tragenden Substrates mittels einer Werkstück-Bühne (z.B. Piezo-Tisch) erfolgen.

Die Technik der Laserlithografie bzw. des direkten Laserschreibens wird insbesondere bei der Erzeugung von Mikro- oder Nanostrukturen eingesetzt, wenn eine hohe Präzision erwünscht ist und gleichzeitig Gestaltungsfreiheit und Flexibilität in der Formgebung gewährleistet sein soll. Dabei ist die Genauigkeit der Strahlführung, der Werkstückhalterung und des gesamten optischen Aufbaus von entscheidender Bedeutung, da dadurch die Güte und Funktionalität der zu erzeugenden Strukturen bestimmt wird.

Die Präzision der Laserlithografievorrichtung hängt wesentlich von der exakten Justierung der optischen und mechanischen Bauteile ab. Eine Laserlithografievorrichtung umfasst eine Vielzahl optischer und mechanischer Funktionselemente, welche eine Vielzahl verschiedener optischer und/oder mechanischer Funktionen bereitstellen, z.B. optische Einrichtungen zur Modulation des Laserstrahls, zur kontrollierten Auslenkung des Laserstrahls und ein Objektiv zur Fokussierung des Laserstrahls und/oder zur Beobachtung des Werkstückes.

Bei bekannten Laserlithografievorrichtungen werden die optischen und/oder mechanischen Funktionselemente meist mittels Einzelteilhalterungen, Schrauben oder Pratzen auf Haltetischen befestigt.

Die Positionsgenauigkeit und Justierung der einzelnen Komponenten wird durch eine Vielzahl von Effekten beeinträchtigt, beispielsweise Temperaturtrift, durch mechanisches Kriechen, z.B. aufgrund von Montagespannungen, oder Eigenschwingungen des Aufbaus. Dies macht die Herstellung und die Wartung der Vorrichtungen problematisch, da die Justierung einer Vielzahl von einzelnen Bauteilen relativ zueinander erforderlich ist. Ein Austausch oder eine Wartung einzelner Bauteile kann dabei im ungünstigen Fall eine komplette Neujustierung einer ganzen Bauteilgruppe oder sogar des gesamten Aufbaus erforderlich machen.

EP1975980 A1, WO2010044268 A1, US2012287411 A1 und US2014043676 A1 offenbaren modular aufgebaute Laserlithografievorrichtungen.

Die Aufgabe der vorliegenden Erfindung besteht darin, für Laserlithografievorrichtungen die Justierung der einzelnen Funktionselemente zu vereinfachen und einen robusten Aufbau und Betrieb zu ermöglichen.

Diese Aufgabe wird durch ein System zum Aufbau einer Laserlithografievorrichtung gemäß Anspruch 1 gelöst. Bei diesem System handelt es sich um ein Set bzw. eine Sachgesamtheit von modularen Bauelementen, die zu einer Laserlithografievorrichtung zusammengefügt werden können, insbesondere im Sinne eines Baukastens. Die Erfindung betrifft aber auch eine insbesondere modular aufgebaute Laserlithografievorrichtung selbst, mit den Komponenten des nachfolgend beschriebenen Systems.

Das System umfasst eine Mehrzahl von Modulen mit optischen und/oder mechanischen Funktionen sowie einen Modulträger. Der Modulträger ist derart ausgebildet, dass zum Aufbau der Laserlithografievorrichtung die mehreren Module an den Modulträger angefügt werden und dort gegebenenfalls fixiert werden. Der Modulträger umfasst eine untere Trägerplatte und eine obere Trägerplatte, die im Benutzungszustand vertikal oberhalb der unteren Trägerplatte angeordnet ist. Ferner umfasst der Modulträger einen Abstandshalter, welcher derart mit der unteren Trägerplatte und der oberen Trägerplatte verbunden ist, dass die beiden Trägerplatten in definierter Lage zueinander und in einem definierten Abstand zueinander fixiert sind. Insbesondere verbindet der Abstandshalter die untere Trägerplatte mit der oberen Trägerplatte.

Beide Trägerplatten erstrecken sich länglich entlang einer Längsrichtung, d.h. die Ausdehnung der jeweiligen Trägerplatte entlang der Längsrichtung ist größer als senkrecht zu der Längsrichtung. Insbesondere sind die Trägerplatten insgesamt schienenartig oder im Wesentlichen rechteckig ausgebildet. Die untere Trägerplatte und die obere Trägerplatte weisen jeweils wenigstens eine sich entlang der Längsrichtung erstreckende Referenzfläche auf. Die Module weisen ihrerseits eine Modulträgerplatte mit einer Justierfläche auf. Referenzfläche und Justierfläche sind derart aufeinander abgestimmt, dass die Referenzfläche und die Justierfläche zum Anfügen der Modulträgerplatten an dem Modulträger aneinander anliegen.

Die Referenzfläche des Modulträgers sowie die Justierflächen der Module sind mit hoher Präzision ausgebildet und geben beim Anfügen der Module an den Modulträger eine genaue Position und Ausrichtung der Module vor. Vorzugsweise beträgt die Formungenauigkeit der Referenzfläche und der Justierfläche höchstens 50 Mikrometer und die Winkelungenauigkeit höchstens 0.05 Grad. Die Referenzfläche und die Justierfläche sind vorzugsweise eben ausgebildet.

Aufgrund der länglichen Ausdehnung der Trägerplatten können mehrere Module nebeneinander entlang der Längsrichtung angefügt werden. Mit anderen Worten werden dadurch eine Vielzahl von Montagestellen nebeneinander entlang der Längsrichtung bereitgestellt, wobei die Montagestellen eine positionsgenaue und ausrichtungsgenaue Anordnung der Module an den Trägerplatten sicherstellen.

Nach einem Aspekt der Erfindung verläuft der Strahlengang zumindest abschnittsweise entlang der Längsrichtung, so dass verschiedene optische und/oder mechanische Funktionen entlang des Lichtweges angeordnet werden können.

Aufgrund des wenigstens eines Abstandshalters wird zwischen der unteren Trägerplatte und der oberen Trägerplatte ein Einbauraum bereitgestellt. Auch in diesem Einbauraum können Module angeordnet sein. Dies ist besonders vorteilhaft für Module mit hohem Eigengewicht, wie beispielsweise einem Lasermodul mit einer Laserlichtquelle oder einem Werkstückmodul mit einem präzise justierbaren Werkstücktisch.

Es ist insbesondere die Gestaltung des Modulträgers, welche eine besonders vorteilhafte Modularisierung der gesamten Optomechanik ermöglicht. Der modulare Aufbau ermöglicht insbesondere, dass die auf einem jeweiligen Modul zusammengefassten optischen und/oder mechanischen Funktionselemente auf dem Modul vorjustiert werden können. Das Modul kann dann in der Gesamtanordnung ausgetauscht werden, ohne dass eine Neujustierung zwingend erforderlich ist. Die Module können auf speziell ausgestalteten Einrichtplätzen bzw. Eichplätzen unabhängig vormontiert und vorjustiert werden. Ferner ist es möglich, für die Module klar definierte und/oder standardisierte Schnittstellen vorzusehen, so dass ein Austausch ohne aufwändige Anschlussarbeiten möglich ist. Dadurch ist es möglich, einzelne Module unabhängig vom übrigen Aufbau weiterzuentwickeln und/oder zu verbessern. Eine Qualitätskontrolle für einzelne Module ist möglich, ohne dass dafür der übrige Aufbau neu justiert werden muss.

Die für eine Lithografievorrichtung erforderlichen optischen und/oder mechanischen oder optomechanischen Funktionen können in vorteilhafterweise auf die verschiedenen Module aufgeteilt werden. Vorzugsweise umfassen die Module ein Lasermodul mit einer Laserquelle zur Abgabe eines Laserstrahls, wenigstens ein Optikmodul zur Modulation und/oder Umformung und/oder Umlenkung des Laserstrahls, sowie ein Werkstückmodul zur Aufnahme und Halterung eines zu erzeugenden und/oder zu bearbeitenden Werkstückes. Die Lithografievorrichtung kann auch weitere Module umfassen, beispielsweise ein Mikroskopmodul, welches derart angeordnet ist und im Strahlengang eingefügt ist, dass das Werkstück und/oder ein durchgeführter Bearbeitungsprozess beobachtbar ist. Ein Optikmodul kann verschiedene Funktionselemente tragen, beispielsweise einen Akusto-optischen Modulator, eine Baugruppe zur Einstellung der Gruppengeschwindigkeitsdispersion, ein oder mehrere justierbare Piezo-Halter, Spiegel-Halter, Linsenhalter, Strahlformeinheit (sog. "spatial filter", diffraktive optische Elemente, refraktive optische Elemente, steuerbare Lichtmodulatoren, und/oder digitale Lichtverarbeitungseinheiten), Galvo-Scanner und/oder Raster-Scanner und/oder Parabol-Scanner zur Auslenkung des Laserstrahls und so weiter.

Vorteilhafterweise sind der Modulträger und die Module derart ausgebildet und aneinander angepasst, dass die Module zum Anfügen an den Modulträger entlang einer gemeinsamen Einbaurichtung an sogenannten Montagestellen des Modulträgers einschiebbar bzw. heranschiebbar sind. Insbesondere sind der Modulträger und die Module derart ausgebildet, dass beim Einschieben bzw. Heranschieben die Justierfläche an der Referenzfläche zum Anliegen kommt. Insbesondere bildet die Referenzfläche einen Endanschlag für die Justierfläche.

Die Montagestellen können diskret oder kontinuierlich entlang der Längsrichtung angeordnet sein. Insbesondere wenn sich die Referenzfläche kontinuierlich entlang der Längsrichtung erstreckt, können mehrere Module an gewünschten Positionen nebeneinander angeordnet werden, wobei eine präzise Justierung durch Referenzfläche und Justierfläche gewährleistet werden kann. Vorzugsweise verläuft die Einbaurichtung senkrecht zur Längsrichtung und in oder parallel zu einer Ebene, in welcher sich die obere Trägerplatte und die untere Trägerplatte erstrecken. Zugänge für Steuerleitungen, Energieversorgung (z.B. Prozessgase oder sonstige Fluide) sowie Informationsschnittstellen können beispielsweise in einem in Einbaurichtung hinten gelegenen Bereich angeordnet werden. Dadurch wird eine Wartung ohne Beeinträchtigung des Aufbaus ermöglicht.

Vorzugsweise ist für jedes Modul eine zugeordnete Befestigungseinrichtung vorgesehen, welche jeweils ein erstes Befestigungsmittel aufweist, welches der Modulplatte zugeordnet ist, sowie ein zweites Befestigungsmittel aufweist, welches dem Modulträger zugeordnet ist. Zusätzlich ist die Befestigungseinrichtung vorzugsweise derart ausgebildet, dass die Modulplatte mit einer durch die Befestigungseinrichtung festgelegten Kraft an eine Auflagefläche des Modulträgers und/oder an die Referenzfläche angedrückt wird. Um die festgelegte Kraft zu erzeugen bzw. die Kraft festzulegen, umfasst die Befestigungseinrichtung vorzugsweise ein Halteelement, welches mit den beiden Befestigungsmitteln derart zusammenwirken, dass eine definierte Anpresskraft ausgeübt wird oder die Anpresskraft auf eine vorgegebene Maximalkraft limitiert ist. Beispielsweise kann das erste Befestigungsmittel ein Loch der Modulplatte sein und das zweite Befestigungsmittel eine Nut an dem Modulträger umfassen, wobei das Halteelement eine Schraube ist, die durch das Loch in der Modulplatte in ein geeignetes Widerlager (z.B. Nutenstein, Mutter für die Schreibe o.ä.) in der Nut eingeschraubt wird und durch ein entsprechend ausgebildetes Federelement zu einer begrenzten Anpresskraft führt.

Die verschiedenen Module sind vorzugsweise derart angeordnet, dass ausgehend von der Laserquelle ein Strahlengang definiert ist, der abschnittsweise zwischen unterer und oberer Trägerplatte und abschnittsweise oberhalb der oberen Trägerplatte verläuft. Konkret kann beispielsweise vorgesehen sein, dass der Strahlengang ausgehend von der Laserquelle zunächst zwischen unterer Trägerplatte und oberer Trägerplatte, vorzugsweise in einer Ebene und vorzugsweise parallel zur Längsrichtung verläuft, dann im weiteren Verlauf insbesondere durch ein Durchstrahlloch im Abstandshalter hindurch verläuft und danach über eine Umlenkeinrichtung, die an einem Randabschnitt an einem Ende bezüglich der Längsrichtung der unteren Trägerplatte angeordnet ist, nach oberhalb der Trägerplatte umgelenkt wird. Die Umlenkeinrichtung kann beispielsweise in der Art einer Periskop-Spiegel-Einrichtung ausgestaltet sein. Vorzugsweise verläuft der Strahlengang dann oberhalb der oberen Trägerplatte entlang der Längsrichtung, insbesondere entgegengesetzt zu dem Strahlengang zwischen unterer Trägerplatte und oberer Trägerplatte. Insofern ist der Strahlenverlauf unterhalb der oberen Trägerplatte, vorzugsweise im Wesentlichen entgegengesetzt zu dem Strahlenverlauf oberhalb der oberen Trägerplatte. Der Strahlenverlauf oberhalb der oberen Trägerplatte bezeichnet insofern einen Strahlenverlauf auf einer der unteren Trägerplatte abgewandten Oberseite der oberen Trägerplatte. Zur weiteren Ausgestaltung kann der Strahlengang dann an einem Randabschnitt der oberen Trägerplatte wieder nach unten umgelenkt werden, beispielsweise durch einen Strahldurchgang hindurch, wie nachfolgend noch näher erläutert. Insgesamt kann durch diese Ausgestaltung der Strahlengang um die verschiedenen Abschnitte des Modulträgers herum gefaltet werden und dadurch ein kompakter Aufbau mit ausreichend Bauraum für zahlreiche optische und mechanische Funktionen bereitgestellt werden.

Die jeweilige Modulträgerplatte weist vorzugsweise eine Unterseite zur Auflage auf einer Auflagefläche des Modulträgers auf und eine gegenüberliegende Oberseite zur Anordnung von optischen und/oder mechanischen Funktionselementen. Die Unterseite sowie die Auflagefläche sind vorzugsweise hochpräzise als ebene Flächen ausgearbeitet. Zur weiteren Ausgestaltung ist an der Oberseite der Modulträgerplatte wenigstens eine Vertiefung vorgesehen, in welche ein optisches und/oder mechanisches Funktionselement des jeweiligen Moduls passgenau eingefügt ist. Insofern verfügt die Oberseite über formgenaue Ausnehmungen zur Anordnung von Funktionselementen (z.B. Linsenhaltern, Spiegelhaltern, Piezo-Aktoren usw.) des jeweils zugeordneten Moduls. Dadurch wird Justierung und Wartung sowie die Herstellung des Moduls vereinfacht.

Zur Lösung der gestellten Aufgabe trägt insbesondere die Ausgestaltung des Modulträgers bei, was im Folgenden näher erläutert wird.

Vorzugsweise sind die obere und untere Trägerplatte jeweils plattenartig ausgestaltet und weisen eine insgesamt ebene Grundform auf. Dabei sind untere Trägerplatte und obere Trägerplatte insbesondere derart angeordnet, dass sich die beiden Trägerplatten (bzw. die jeweiligen ebenen Grundformen der Trägerplatten) parallel zueinander erstrecken. Der Abstand der beiden Trägerplatten wird dann durch den Abstandshalter vorgegeben.

Zur weiteren Ausgestaltung weist der Abstandshalter des Modulträgers ein Durchstrahlloch auf, welches einen parallel zur Längsrichtung verlaufenden und insbesondere geraden Strahlweg freigibt. Mit anderen Worten ist das Durchstrahlloch derart ausgebildet, dass ein Strahl entlang der Längsrichtung durch das Durchstrahlloch ungestört hindurchtreten kann. Dies ermöglicht es, einen Laserstrahl aus dem zwischen oberer Trägerplatte und unterer Trägerplatte und Abstandshalter bereitgestellten Bauraum hinaus zu führen und beispielsweise mit einer geeigneten Umlenkeinrichtung in einen Bereich oberhalb der oberen Trägerplatte umzulenken.

Zur weiteren Ausgestaltung kann die obere Trägerplatte einen Strahldurchgang aufweisen, welcher einen insbesondere geraden Strahlweg von einer Oberseite zu einer Unterseite der oberen Trägerplatte freigibt. Insofern kann durch den Strahldurchgang aus einem Bereich oberhalb der oberen Trägerplatte in den Zwischenraum zwischen oberer und unterer Trägerplatte hindurchgestrahlt werden. Beispielsweise können auf der Oberseite der oberen Trägerplatte Optikmodule angeordnet sein, mittels welchen aus einem von einer Laserquelle abgegebenen Laserstrahl ein Schreibstrahl geformt wird, der für die Zwecke der Laserlithografie geeignet ist. Dieser Strahl kann dann beispielsweise durch den Strahldurchgang wieder platzsparend nach unten geführt werden und dort beispielsweise auf das Werkstückmodul treffen.

Der Strahldurchgang kann beispielsweise als randoffene Ausnehmung ausgestaltet sein. Die randoffene Ausnehmung ist vorzugsweise offen zu einer die Trägerplatte in Längsrichtung begrenzenden Stirnseite. Insgesamt kann die randoffene Ausnehmung U-förmig ausgebildet sein, vorzugsweise in der Art einer vom Rand bzw. von der Stirnseite her eingebrachten, U-förmigen Ausnehmung.

Die randoffene Ausnehmung ist insbesondere so ausgebildet, dass an der oberen Trägerplatte zwei sich entlang der Längsrichtung erstreckende Schenkel ausgebildet sind, welche die Ausnehmung begrenzen. Auf diesen können beispielsweise optische Elemente und/oder Sensoren für den Strahlengang unmittelbar vor dem Werkstück angeordnet werden.

Zur weiteren Ausgestaltung sind der Abstandshalter mit dem darin vorgesehenen Durchstrahlloch und der Strahldurchgang an der oberen Trägerplatte an jeweils gegenüberliegenden Endabschnitten des Modulträgers positioniert. Vorzugsweise liegen die beiden Endabschnitte entlang der Längsrichtung einander gegenüber.

Eine vorteilhafte Ausgestaltung ergibt sich dadurch, dass zwei oder mehr Abstandshalter vorgesehen sind, welche an verschiedenen Positionen entlang der Längsrichtung derart angeordnet sind, dass wenigstens ein Zwischenraum zwischen unterer und oberer Trägerplatte und den Abstandshaltern begrenzt ist. Dieser Zwischenraum definiert eine besonders geschützte Einbauposition, in welcher beispielsweise die Laserquelle angeordnet sein kann. Aus dem Zwischenraum kann der Laserstrahl beispielweise durch das oben genannte Durchstrahlloch hinausgeführt werden. Der Schwerpunkt der gesamten Vorrichtung liegt dann tief, was zur Stabilität beiträgt.

Der Abstandshalter ist vorzugsweise ebenfalls plattenartig ausgebildet und erstreckt sich senkrecht zur Längsrichtung, insbesondere auch senkrecht zu der unteren und oberen Trägerplatte. Diese Konstruktion verleiht dem Modulträger eine hohe Stabilität und ermöglicht es, die Anfälligkeit für Eigenschwingungen und Resonanzphänomene zu verringern. Dadurch wird die Präzision der gesamten Vorrichtung verbessert. Insbesondere dann, wenn zwei versetzt angeordnete Abstandshalter vorgesehen sind, können Resonanzphänomene und Eigenschwingungen wirksam unterdrückt werden.

Nach einem vorteilhaften Aspekt erstreckt sich die Referenzfläche durchgehend über die volle Ausdehnung der jeweiligen Trägerplatte entlang der Längsrichtung, wodurch hohe Gestaltungsfreiheit beim Aufbau der Vorrichtung erzielt wird.

Die obere Trägerplatte und die untere Trägerplatte weisen vorzugsweise eine plattenartige ebene Grundform auf, für die jeweils eine Erstreckungsebene definiert ist. Die Referenzfläche erstreckt sich dann vorzugsweise senkrecht zu der Erstreckungsebene der jeweiligen Trägerplatte und verläuft entlang der Längsrichtung. Insofern ist die Referenzfläche vorzugsweise eine ebene Fläche, die parallel zur Längsrichtung und senkrecht zu den Erstreckungsebenen der Trägerplatten verläuft.

Im Querschnitt senkrecht zur Längserstreckung sind die Trägerplatten vorzugsweise stufenartig ausgebildet, mit einer ersten Stufe, welche durch die Auflagefläche gebildet ist und welche durch die senkrecht hierzu verlaufende Referenzfläche begrenzt ist. Konkret kann dies z.B. dadurch erreicht werden, dass die Oberseite der unteren und der oberen Trägerplatte eine senkrecht zur Längsrichtung randoffene Vertiefung aufweist, welche eine ebene Bodenfläche hat. Diese ebene Bodenfläche bildet die Auflagefläche für die Modulträgerplatten. Die randoffene Vertiefung wird vorzugsweise entgegengesetzt zu ihrem randoffenen Bereich von der Referenzfläche als Stirnfläche begrenzt. Insofern ist die Vertiefung vorzugsweise entgegengesetzt zur Einbaurichtung hin randoffen. Die Referenzfläche begrenzt die Vertiefung dann in Einbaurichtung und bildet einen Anschlag. Dies ermöglicht es, die Modulträgerplatte eines Modulträgers entlang der Einbaurichtung auf die Trägerplatte des Modulträgers zu schieben, bis die Stirnseite der Modulträgerplatte (welche die Justierfläche bildet) an die Referenzfläche anstößt. Zur weiteren Ausgestaltung weist die Oberseite der unteren und/oder der oberen Trägerplatte wenigstens eine Nut auf, welche sich entlang der Längsrichtung erstreckt und welche zur Aufnahme eines Halteelements einer Befestigungseinrichtung für Modulplatten ausgebildet ist. Insofern weist die Nut vorzugsweise eine Hinterschneidung auf, in welche ein entsprechend ausgebildetes Halteelement eingreifen kann. Als Halteelement können beispielsweise Schrauben vorgesehen sein, welche einerseits in einen Nutenstein für die Nut und andererseits mit einer Mutter verschraubt werden. Dabei kann beispielsweise zwischen Mutter und Platte eine Feder zur Aufbringung einer definierten Anpresskraft wirken. Vorzugsweise verläuft die Nut in der oben genannten Auflagefläche der Trägerplatte. Zur weiteren Ausgestaltung können die Nuten mit Einlegeprofilen versehen sein, welche entsprechende Hinterschneidungen zur Anlage und Fixierung des Halteelements bereitstellen.

Nach einem vorteilhaften Aspekt der Erfindung ist der wenigstens eine Abstandhalter, die untere Trägerplatte und die obere Trägerplatte einstückig ausgebildet. Eine solche monolithische Ausgestaltung ermöglicht hohe Festigkeit, hohe Präzision und geringe temperaturbedingte Geometrieänderungen. Ein massiver Modulträger führt beispielsweise auch zu einer vergleichsweise hohen Wärmekapazität und verringert dadurch das Risiko einer temperaturbedingten Verformung.

Für den Modulträger können verschiedene Materialien vorteilhaft sein. So ermöglicht beispielsweise Granit eine hohe Genauigkeit und Temperaturbeständigkeit. Auch Aluminium, insbesondere Alu-Guss, oder Messing können vorteilhafte Eigenschaften aufweisen.

Die Erfindung wird im Folgenden anhand der Figuren näher erläutert.

Es zeigen:
- Figur 1: schematische Darstellung zur Erläuterung des Strahlengangs einer Laserlithografievorrichtung und die Funktionen von Modulen und/oder Funktionselementen;
- Figur 2: perspektivische Darstellung einer Ausführungsform eines Systems zum Aufbau einer Laserlithografievorrichtung;
- Figur 3: Modulträger der Laserlithografievorrichtung gemäß Figur 2;
- Figur 4: Darstellung eines Strahlenganges an dem Modulträger gemäß Figur 3;
- Figur 5 und Figur 6: perspektivische Ansichten weiterer Ausgestaltungen des Modulträgers;
- Figur 7 und Figur 8: Skizzierte Darstellung zur Erläuterung des Anfügens einer Modulträgerplatte an einen Modulträger;
- Figur 9: Detailansicht zur Erläuterung einer Befestigungseinrichtung zum Anfügen einer Modulträgerplatte an dem Modulträger;
- Figur 10: Ansicht auf eine Oberseite einer Modulträgerplatte zur Erläuterung weiterer Ausgestaltungen.

In den Figuren sowie in der nachfolgenden Beschreibung sind für identische oder einander entsprechende Merkmale jeweils dieselben Bezugszeichen verwendet.

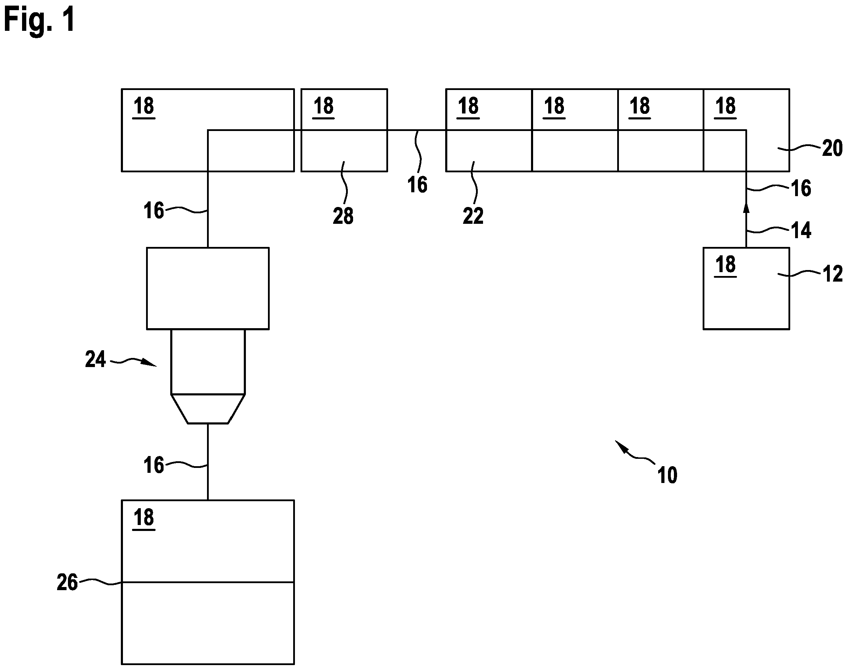

Figur 1 zeigt eine Skizze zur Erläuterung der Funktionen von Komponenten einer modular aufgebauten Laserlithografievorrichtung 10. Die Laserlithografievorrichtung 10 umfasst beispielhaft ein Lasermodul 12 mit einer nicht näher dargestellten Laserquelle zur Abgabe eines Laserstrahls 14. Für den Laserstrahl 14 kann ein Strahlengang 16 durch die Laserlithografievorrichtung 10 angegeben werden. Der Strahlengang 16 verläuft im dargestellten Beispiel durch mehrere Module 18 mit optischen und/oder mechanischen Funktionen. Insofern ist auch das Lasermodul 12 ein Modul 18, das eine optische Funktion bereitstellt. Beispielsweise kann der Strahlengang 16 zunächst durch ein Modulations-Modul 20 zur Formung von geeigneten Strahlpulsen verlaufen und dann gegebenenfalls über weitere Module 18 durch ein Strahllenkungsmodul 22, welches beispielsweise eine Galvo-Scanner-Einheit zur kontrollierten Auslenkung des Laserstrahls 14 umfasst. Der Strahlengang 16 verläuft im dargestellten Beispiel weiter durch ein Objektiv-Modul 24 und trifft auf ein Werkstückmodul 26 zur Aufnahme und Halterung eines zu erzeugenden und/oder zu bearbeitenden Werkstückes. Zur Beobachtung des Werkstückes und/oder des Bearbeitungsprozesses kann im Strahlengang auch ein Kamera-Modul 28 angeordnet sein.

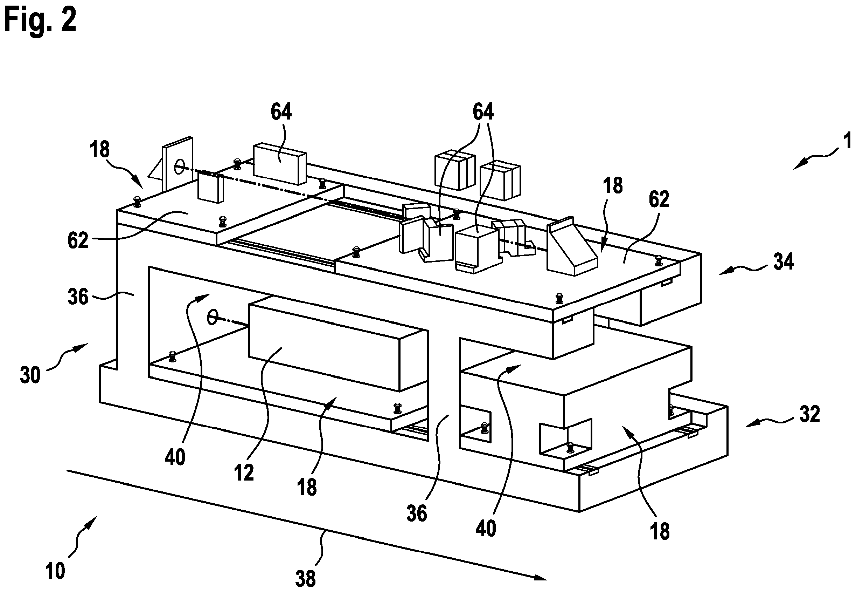

Bei der in Figur 2 gezeigten Ausführungsform der Lithografievorrichtung 10 sind verschiedene Module 18 auf einem Modulträger 30 angeordnet. Insofern ist die Lithografievorrichtung 10 modular aufgebaut und umfasst eine Mehrzahl von Modulen 18 sowie einen Modulträger 30, an welchem die Module 18 angefügt sind. Mit anderen Worten bilden der Modulträger 30 und die Module 18 ein System 1 zum Aufbau der modular aufgebauten Lithografievorrichtung 10.

Der Modulträger 30 umfasst eine vertikal unten liegende untere Trägerplatte 32 sowie eine vertikal oben liegende obere Trägerplatte 34. Die Trägerplatten 32 und 34 sind im dargestellten Beispiel mittels zweier Abstandshalter 36 miteinander verbunden.

Wie nachfolgend noch näher erläutert, weisen die Trägerplatten 32, 34 eine plattenartige Grundform auf, die insgesamt rechteckig ist. Die Trägerplatten 32, 34 erstrecken sich entlang einer Längsrichtung 38. Entlang der Längsrichtung 38 können mehrere Module 18 an die obere Trägerplatte 34 und/oder an die untere Trägerplatte 32 angefügt werden, wie nachfolgend noch näher erläutert. Im dargestellten Beispiel sind die Trägerplatten 32, 34 mit zwei entlang der Längsrichtung 38 voneinander beabstandeten Abstandshaltern 36 verbunden. Durch die zwei Abstandshalter 36 und die Trägerplatten 32, 34 werden im dargestellten Beispiel zwei Einbauräume 40 zwischen unterer Trägerplatte 32 und oberer Trägerplatte 34 bereitgestellt. Oberhalb der oberen Trägerplatte wird ebenfalls Bauraum zur Anordnung von Modulen bereitgestellt.

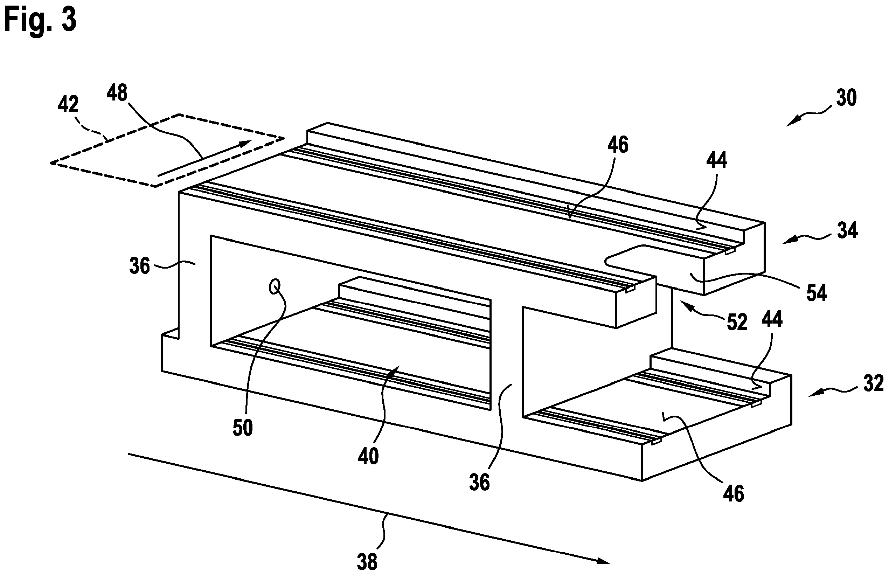

In der Figur 3 ist der Modulträger 30 ohne angefügte Module 18 dargestellt. Für die Trägerplatten 32, die jeweils eine plattenartige, ebene Grundform aufweisen, ist jeweils eine Erstreckungsebene 42 definiert (beispielhaft nur für die obere Trägerplatte 34 skizziert). Die Trägerplatten 32 und 34 erstrecken sich insofern parallel zueinander. Die Trägerplatten 32 und 34 weisen jeweils eine sich entlang der Längsrichtung 38 erstreckende Referenzfläche 44 auf. Die Referenzfläche 44 erstreckt sich insbesondere senkrecht zu der Erstreckungsebene 42 der Trägerplatten 32 und 34. Insofern hat die Oberseite einer jeweiligen Trägerplatte 32, 34 insbesondere einen stufenartigen Verlauf, wobei eine tiefliegende Stufe der Oberseite wenigstens eine Auflagefläche 46 bereitstellt, welche von der Referenzfläche 44 als Stirnfläche begrenzt ist.

Dies ermöglicht es, Module 18, wie nachfolgend noch näher erläutert, entlang einer Einbaurichtung 48 an die untere bzw. obere Trägerplatte 32 bzw. 34 anzuschieben und anzufügen, wobei durch die Referenzfläche 44 ein Anschlag für eine Stirnfläche der Module (siehe unten: Justierfläche) bereitgestellt wird.

Vorteilhaft ist, wenn zumindest ein Abstandshalter 36 ein Durchstrahlloch 50 aufweist, welches einen Strahlweg entlang der Längsrichtung 38 freigibt. Die obere Trägerplatte 34 kann zur weiteren Ausgestaltung ebenfalls einen Strahldurchgang 52 aufweisen, welcher einen Strahlweg von einem Bereich oberhalb der oberen Trägerplatte 34 in einen Zwischenraum zwischen oberer Trägerplatte 34 und unterer Trägerplatte 32 freigibt. Der Strahldurchgang 52 kann beispielsweise als randoffene Ausnehmung 54 ausgebildet sein, die sich vorzugsweise U-förmig ausgehend von einem Endabschnitt der oberen Trägerplatte 34 erstreckt. Vorteilhaft ist, wenn das Durchstrahlloch in einem Abstandshalter 36 angeordnet ist, welcher bezüglich der Längsrichtung 38 gegenüberliegend zu dem Strahldurchgang 52 angeordnet ist.

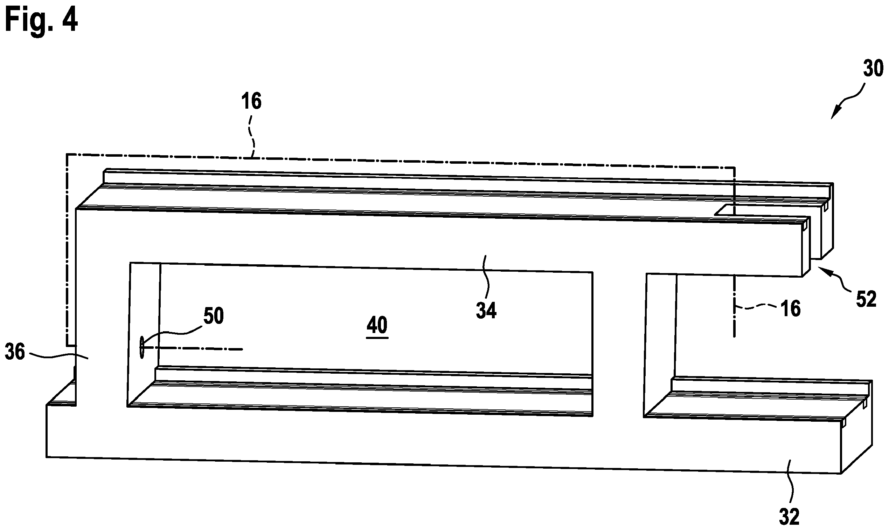

Diese Ausgestaltung ermöglicht einen Strahlengang 16 für die Laserlithografie verwendeten Laserstrahlen, wie er in der Figur 4 relativ zu dem Modulträger 30 dargestellt ist. Ausgehend von dem Einbauraum 40 zwischen oberer und unterer Trägerplatte 32, 34 verläuft der Strahlengang 16 zunächst durch das Durchstrahlloch 50 in dem Abstandshalter 36 und wird dann mittels einer nicht näher dargestellten Umlenkeinrichtung nach oben in einen Bereich oberhalb der oberen Trägerplatte 34 gelenkt. Der Strahlengang 16 verläuft dann weiter entlang der oberen Trägerplatte 34 zu dem entgegengesetzten Endabschnitt der oberen Trägerplatte 34 und schließlich durch den Strahldurchgang 52 wieder zurück in einen Zwischenraum zwischen oberer Trägerplatte 34 und unterer Trägerplatte 32. Dieser gefaltete Strahlenverlauf ermöglicht es, mehrere Module 18 entlang des Strahlengangs 16 auf einem kompakten Bauraum anzuordnen.

In den Figuren 2 bis 4 ist der Modulträger 30 in der Art eines massiven Bauteils, insbesondere monolithisch aus einem Material (beispielsweise Granit) ausgebildet.

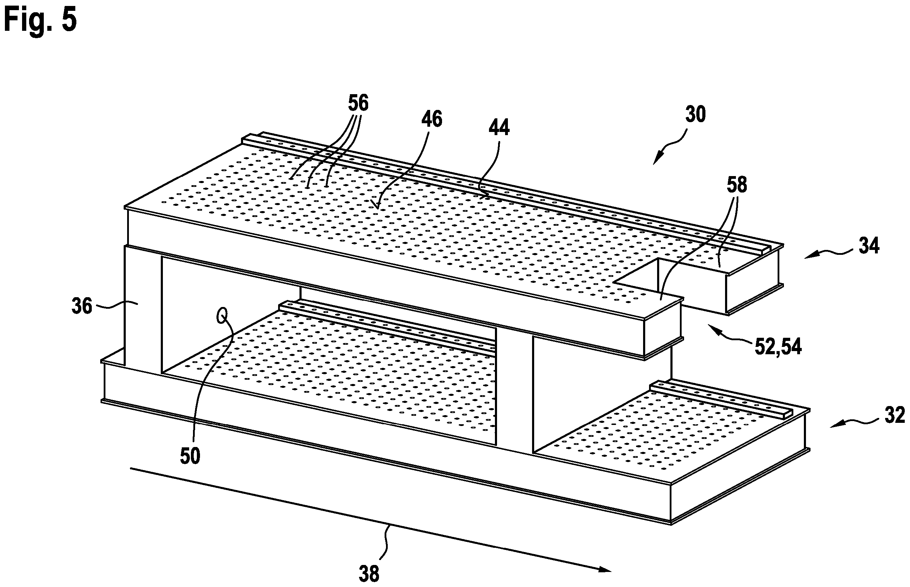

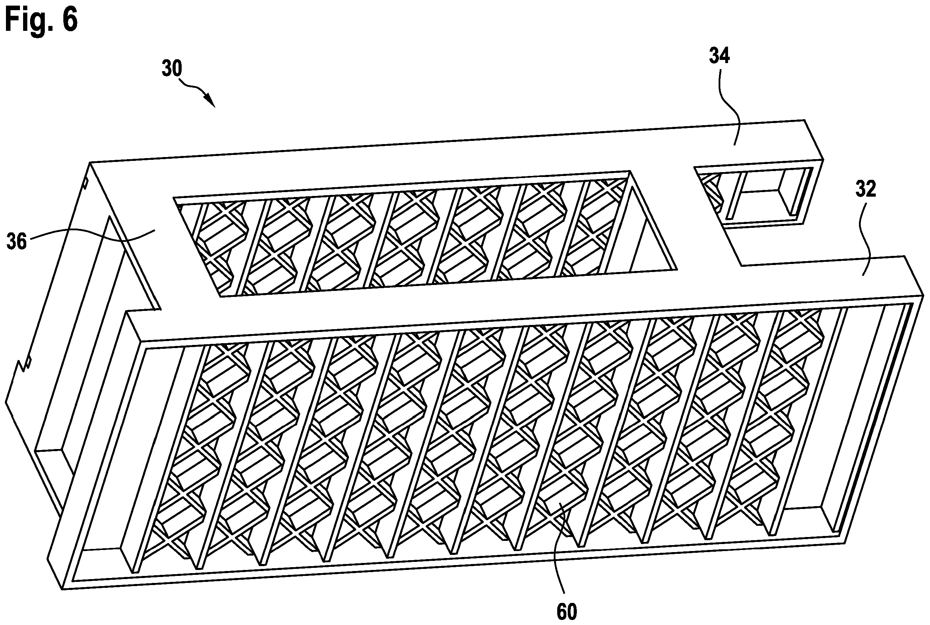

Die Figuren 5 und 6 zeigen weitere Ausgestaltungsmöglichkeiten für den Modulträger 30. Im Beispiel der Figur 5 sind untere Trägerplatte 32 und obere Trägerplatte 34 in der Art eines für Laboranwendungen üblichen Montagetisches mit einer regelmäßigen, matrixartigen Anordnung von Montagelöchern 56 ausgebildet. Derartige Montageoberflächen sind oft als sogenannte "Bread-Boards" bezeichnet. Bei derartigen Ausgestaltungen bildet die Oberfläche in der Umgebung der Montagelöcher 56 die Auflagefläche 46. Die Referenzfläche 44 erstreckt sich wiederum senkrecht zur Auflagefläche 46.

Hinsichtlich des Strahldurchgangs 52 ist am Beispiel der Figur 5 erkennbar, dass die Ausgestaltung der randoffenen Ausnehmung 54 derart erfolgen kann, dass jeweils neben der randoffenen Ausnehmung 54 zwei sich entlang der Längsrichtung 38 erstreckende Schenkel 58 gebildet sind. Die Schenkel 58 sind Teil der oberen Trägerplatte 34 und ermöglichen ebenfalls die Anordnung von optischen und/oder mechanischen Funktionselementen. Derartige Ausgestaltungen sind selbstverständlich unabhängig von der konkreten Materialwahl und Ausgestaltung des Modulträgers 30 und sind beispielhaft auch in den Figuren 2 bis 4 verwirklicht.

Die Figur 6 zeigt einen Modulträger 30, bei dem untere Trägerplatte und obere Trägerplatte 32, 34 mit einer stabilisierenden Wabenstruktur 60 ausgestaltet sind. Solche Strukturen können beispielsweise im Druckguss-Verfahren aus Metall, beispielsweise Aluminium, hergestellt werden und weisen hohe mechanische Festigkeit auf.

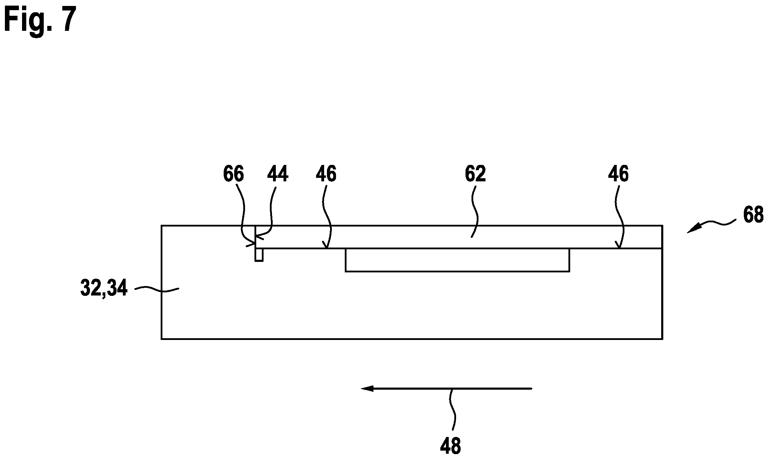

Anhand der Figuren 7 bis 9 wird der Aufbau der Module 18 und die positionsgenaue Anordnung der Module 18 an dem Modulträger 30 näher erläutert. Figur 7 zeigt hierzu in skizzierter Darstellung einen Längsschnitt durch eine der Trägerschienen 32 bzw. 34 senkrecht zur Längsrichtung 38. Die Module 18 weisen jeweils eine Modulträgerplatte 62 auf, auf welcher die in dem Modul zusammengefassten optischen und/oder mechanischen Funktionselemente 64 angeordnet sind (vgl. beispielsweise Figur 2). Eine Vorderseite der Modulträgerplatte 62 stellt eine Justierfläche 66 bereit. Zum Anfügen des Moduls 18 an den Modulträger 30 wird das Modul 18 mit seiner Modulträgerplatte 62 derart angeordnet, dass die Justierfläche 66 an der Referenzfläche 44 der jeweiligen Trägerplatte 32, 34 anliegt (vgl. Figur 7). Die geometrischen Verhältnisse sind vorzugsweise derart gewählt, dass dann, wenn die Justierfläche 66 an der Referenzfläche 44 anliegt, eine Unterseite der Modulträgerplatte 62 bündig und passgenau auf der Auflagefläche 46 der jeweiligen Trägerplatte 32, 34 aufliegt.

Wie erläutert, weist die Trägerplatte 32, 34 im Querschnitt senkrecht zur Längsrichtung 38 vorzugsweise einen stufenartigen Verlauf auf. Dies kann beispielsweise dadurch realisiert werden, dass bei einer im Wesentlichen rechteckige Grundform einer Trägerplatte 32, 34 eine senkrecht zur Längsrichtung randoffene Vertiefung 68 vorgesehen ist, deren Bodenfläche die Auflagefläche 46 bildet und deren die Bodenfläche 46 in Einbaurichtung 48 begrenzende Stirnfläche die Referenzfläche 44 bildet (vgl. Figur 7).

Zum Anfügen des Moduls 18 wird die Modulträgerplatte 62 entlang der Einbaurichtung 48 derart eingeschoben, dass die Unterseite der Modulträgerplatte 62 auf der Auflagefläche 46 aufliegt und die Justierfläche 66 an der Referenzfläche 44 anstößt. Insofern definieren die Trägerplatten 32, 34 mit ihrer Referenzfläche 44 und der Auflagefläche 46 eine Mehrzahl von Montagestellen 68, die entlang der Längsrichtung 38 nebeneinander liegen.

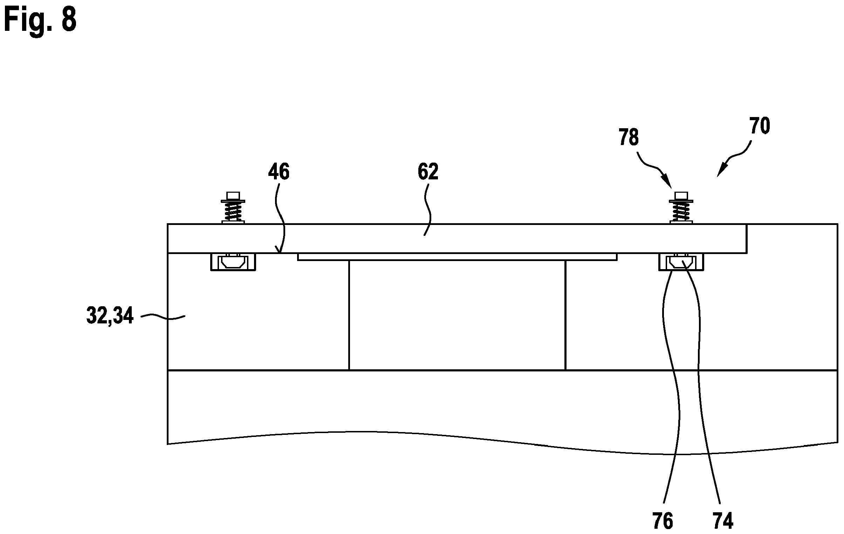

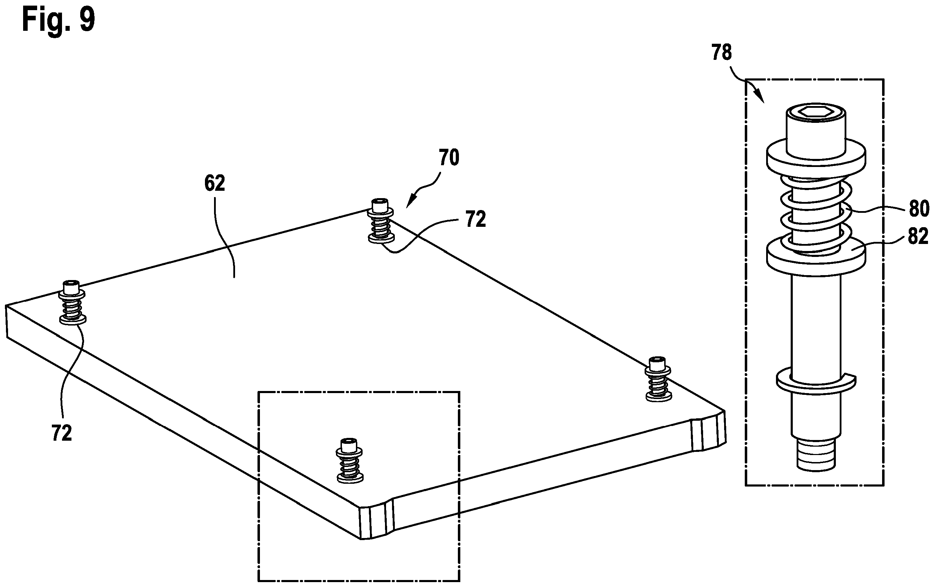

Zum Befestigen der Modulträgerplatte 62 an der jeweiligen Trägerplatte 32, 34 ist eine Befestigungseinrichtung 70 vorgesehen, die anhand der Figuren 8 und 9 näher erläutert wird. Die Befestigungseinrichtung umfasst erste Befestigungsmittel 72, die der jeweiligen Trägerplatte 32, 34 zugeordnet sind. Im dargestellten Beispiel werden die ersten Befestigungsmittel 72 von Durchgangslöchern in der Modulträgerplatte 62 bereitgestellt. Auf Seiten der jeweiligen Trägerplatte 32, 34 sind zweite Befestigungsmittel 74 vorgesehen, die im dargestellten Beispiel eine sich entlang der Längsrichtung 38 erstreckende Nut 76 in einer Oberseite der jeweiligen Trägerplatte 32, 34 umfassen. Die Fixierung der Modulträgerplatte 62 erfolgt dann dadurch, dass ein Halteelement 78 der Befestigungseinrichtung 70 durch das als Loch ausgestaltete erste Befestigungsmittel 72 hindurchgreift und mit einem Gegenstück am zweiten Befestigungsmittel 74 (z.B. Nutenstein in der Nut 76) fixiert wird. Vorzugsweise ist hierzu die Nut 76 mit einer Hinterschneidung versehen, so dass die Halterung (z.B. Nutenstein) für das Halteelement 78 gegen Herausfallen aus der Nut 76 gesichert ist. Wie beispielsweise in Figur 3 erkennbar, kann in die Nut ein Einlegeprofil mit einer Hinterschneidung eingearbeitet sein.

Das Halteelement 78 kann Ausgestaltungen aufweisen, mittels welcher beim Fixieren der Modulträgerplatte 62 an der jeweiligen Trägerplatte 32, 34 eine vordefinierte Kraft oder eine durch eine Maximalkraft limitierte Kraft als Anpresskraft zwischen einer Unterseite der Modulträgerplatte 62 und der Auflagefläche 46 wirkt. Dadurch werden Ungenauigkeiten in der Justierung reduziert, die durch ungleichmäßige Anpresskräfte hervorgerufen werden können. Wie in der Detaildarstellung der Figur 9 erkennbar, kann dies beispielsweise dadurch erreicht werden, dass das Halteelement 78 in der Art einer Schraube ausgestaltet ist, welche durch das Loch (erstes Befestigungsmittel 72) der Modulträgerplatte 62 in das zweite Befestigungsmittel 74 (Nut 76) eingreift, wobei ein an der Schraube angreifendes Federmittel 80 vorgesehen ist, welches sich mit einem Anlageelement 82 an einer Oberseite der Modulträgerplatte 62 abstützt. Durch Eindrehen der Schraube in das zweite Befestigungsmittel wird das Federmittel komprimiert und kann eine limitierte Kraft vorgeben werden.

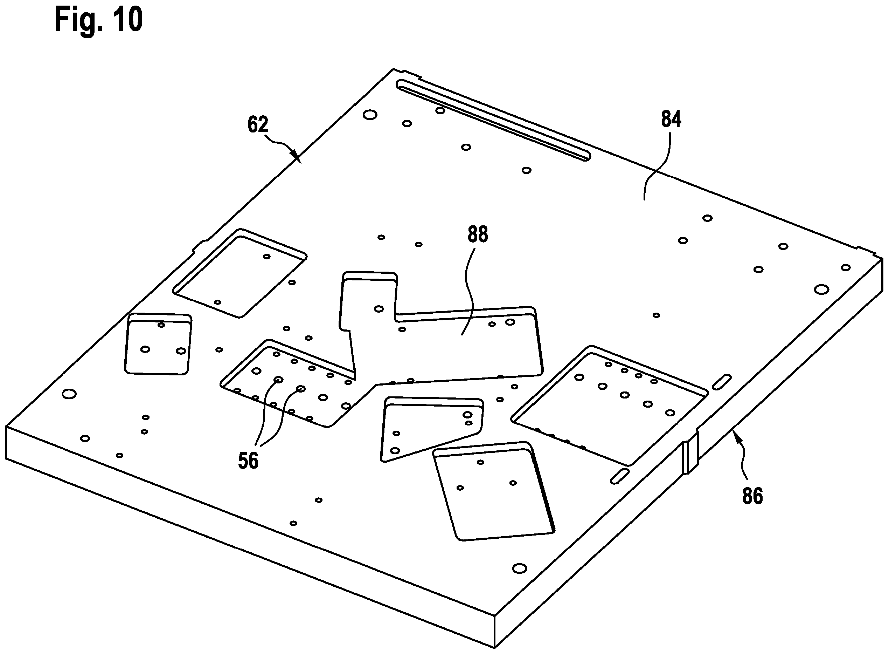

Wie in Figur 10 dargestellt, kann die Modulträgerplatte 62 an ihrer Oberseite 84 wenigstens eine Vertiefung 88 aufweisen, welche passgenau an die äußeren Konturen eines jeweiligen Funktionselements 64 angepasst ist, welches auf der Modulträgerplatte 62 angeordnet ist (vgl. auch Figur 2). Mit der Unterseite 86 (also die der Oberseite 84 gegenüberliegende Seite) wird die Modulträgerplatte 82 an den Trägerplatten 32, 34 angefügt, insbesondere auf eine entsprechende Auflagefläche 46 aufgelegt (vgl. Figuren 7 und 8). In der wenigstens einen Vertiefung 88 können wiederum Montagelöcher 56 vorgesehen sein, um das jeweilige Funktionselement zu fixieren. Auch außerhalb der Vertiefungen sind Montagelöcher 56 denkbar, beispielsweise um Zuleitungen und sonstige Zusatzelemente zu fixieren.

## Patentansprüche

1. System (1) zum Aufbau einer Laserlithografievorrichtung,
umfassend eine Mehrzahl von Modulen (18) mit optischen und/oder mechanischen Funktionen und einen Modulträger (30), welcher derart ausgebildet ist, dass zum Aufbau der Laserlithografievorrichtung (10) die mehreren Module (18) an den Modulträger (30) anfügbar sind;
wobei der Modulträger (30) eine untere Trägerplatte (32) und eine obere Trägerplatte (34) und einen Abstandshalter (36) aufweist, wobei der Abstandshalter (36) zwischen unterer Trägerplatte (32) und oberer Trägerplatte (34) angeordnet ist und diese in definierter Lage zueinander fixiert,
wobei die untere Trägerplatte (32) und die obere Trägerplatte (34) jeweils länglich entlang einer Längsrichtung (38) ausgedehnt ausgebildet sind und jeweils wenigstens eine sich entlang der Längsrichtung (38) erstreckende Referenzfläche (44) aufweisen,
und wobei die Module (18) jeweils eine Modulträgerplatte (62) mit einer Justierfläche (66) aufweisen, wobei zum Anfügen des Moduls (18) an den Modulträger (30) die Justierfläche (66) an die Referenzfläche (44) angelegt wird.

2. System (1) nach Anspruch 1, wobei die Module (18) umfassen:
- ein Lasermodul (12) mit einer Laserquelle zur Abgabe eines Laserstrahls (14),
- wenigstens ein Optikmodul (20, 22) zur Modulation, Umformung und/oder Umlenkung des Laserstrahls (14), und
- ein Werkstückmodul (26) zur Aufnahme und Halterung eines zu Erzeugenden und/oder zu bearbeitenden Werkstücks.

3. System (1) nach Anspruch 1 oder 2, wobei der Modulträger (30) und die Module (18) derart ausgebildet sind, dass die Module (18) zum Anfügen an den Modulträger (30) entlang einer gemeinsamen Einbaurichtung (48) derart an Montagestellen (68) des Modulträgers (30) einschiebbar sind, dass die Justierfläche (66) an der Referenzfläche (44) zum Anliegen kommt.

4. System (1) nach einem der vorherigen Ansprüche, wobei für jedes Modul eine Befestigungseinrichtung (70) vorgesehen ist, welche ein erstes Befestigungsmittel (72) an der Modulträgerplatte (62) und ein zweites Befestigungsmittel (74) an dem Modulträger (30) umfasst, wobei die Befestigungseinrichtung (70) derart ausgebildet ist, dass die Modulträgerplatte (62) mit einer durch die Konstruktion der Befestigungseinrichtung (70) festgelegten Maximalkraft an eine Auflagefläche (46) des Modulträgers (30) und/oder an die Referenzfläche (44) angedrückt wird.

5. System (1) nach Anspruch 2, wobei die Module (18) derart angeordnet sind, dass ausgehend von der Laserquelle ein Strahlengang (16) für den Laserstrahl (14) definiert ist, welcher zunächst zwischen unterer Trägerplatte (32) und oberer Trägerplatte (34) verläuft, dann über eine an einem Randabschnitt der unteren Trägerplatte(32) angeordnete Umlenkeinrichtung nach oberhalb der oberen Trägerplatte (34) umgelenkt wird, und dann oberhalb der oberen Trägerplatte (34) entlang der Längsrichtung (38) verläuft.

6. System (1) nach einem der vorherigen Ansprüche, wobei die Modulträgerplatte (62) eine Unterseite (86) zur Auflage auf einer Auflagefläche (46) des Modulträgers und eine Oberseite (84) zur Anordnung von optischen und/oder mechanischen Funktionselementen (64) aufweist, wobei an der Oberseite (84) wenigstens eine Vertiefung (88) vorgesehen ist, in welche ein optisches und/oder mechanisches Funktionselement (64) des jeweiligen Moduls passgenau einfügbar ist.

7. Modulträger (30) ausgebildet zur Verwendung in einem System (1) gemäß einem der vorherigen Ansprüche, aufweisend eine untere Trägerplatte (32), eine obere Trägerplatte (34) und einen Abstandshalter (36), wobei der Abstandshalter (36) zwischen unterer Trägerplatte (32) und oberer Trägerplatte (34) angeordnet ist und diese in definierter Lage zueinander fixiert,
wobei die untere Trägerplatte (32) und die obere Trägerplatte (34) jeweils länglich entlang einer Längsrichtung (38) ausgehdehnt ausgebildet sind und jeweils wenigstens eine sich entlang der Längsrichtung (38) erstreckende Referenzfläche (44) aufweisen.

8. Modulträger (30) nach Anspruch 7, wobei die untere Trägerplatte (32) und die obere Trägerplatte (34) plattenartig ebene Grundformen aufweisen die sich parallel zueinander erstrecken.

9. Modulträger (30) nach einem der Ansprüche 7 oder 8, wobei der Abstandshalter (36) ein Durchstrahlloch (50) aufweist, welches einen parallel zur Längsrichtung (38) verlaufenden Strahlweg freigibt.

10. Modulträger (30) nach einem der Ansprüche 7 - 9, wobei die obere Trägerplatte (34) ein Strahldurchgang (52) aufweist, welcher einen Strahlweg von einer Oberseite zu einer Unterseite der oberen Trägerplatte (34) freigibt.

11. Modulträger (30) nach einem der Ansprüche 7 - 10, wobei zwei Abstandshalter (36) vorgesehen sind, welche an verschiedenen Positionen entlang der Längsrichtung (38) derart angeordnet sind, dass ein Zwischenraum (40) zwischen unterer und oberer Trägerplatte und den beiden Abstandshaltern (36) begrenzt ist.

12. Modulträger (30) nach einem der Ansprüche 7 - 11, wobei sich die Referenzfläche (44) durchgehend über die volle Ausdehnung der jeweiligen Trägerplatte (32, 34) erstreckt.

13. Modulträger (30) nach einem der Ansprüche 7 - 12, wobei die untere Trägerplatte (32) und die obere Trägerplatte (34) plattenartig ebene Grundformen aufweisen, für die jeweils eine Erstreckungsebene (42) definiert ist, wobei die jeweilige Referenzfläche (44) senkrecht zu der Erstreckungsebene (42) der jeweiligen Trägerplatte (32, 34) verläuft.

14. Modulträger (30) nach einem der Ansprüche 7 - 13, wobei die Oberseite der unteren und der oberen Trägerplatte (32, 34) eine senkrecht zur Längsrichtung randoffene Vertiefung (54) aufweisen, deren Bodenfläche eine Auflagefläche (46) für Modulträgerplatten (62) bildet, wobei die Vertiefung (54) entgegengesetzt zu ihrem randoffenen Bereich von der Referenzfläche (44) begrenzt ist.

15. Modulträger (30) nach einem der Ansprüche 7 - 14, wobei die Oberseite der unteren und der oberen Trägerplatte (32, 34) wenigstens eine sich entlang der Längsrichtung (38) erstreckende Nut (76) zur Aufnahme eines Haltelements (78) einer Befestigungseinrichtung (70) für Modulträgerplatten (62) aufweist, vorzugsweise eine Nut (76) mit Hinterschneidung.

## Claims

1. System (1) for constructing a laser lithography device, comprising a plurality of modules (18) having optical and/or mechanical functions and a module support (30) which is configured in such a way that for constructing the laser lithography device (10) the plurality of modules (18) can be attached to the module support (30);
wherein the module support (30) comprises a bottom support plate (32) and a top support plate (34) and a spacer (36), wherein the spacer (36) is arranged between the bottom support plate (32) and the top support plate (34) and fixes these in a defined position with respect to each other, wherein the bottom support plate (32) and the top support plate (34) each are configured in longitudinally extension along a longitudinal direction (38) and each comprise at least one reference surface (44) extending along the longitudinal direction (38),
and wherein the modules (18) each comprise a module support plate (62) with an adjustment surface (66), wherein for attaching the module (18) to the module support (30) the adjustment surface (66) is put against the reference surface (44) .

2. System (1) as claimed in claim 1, wherein the modules (18) comprise:
- a laser module (12) with a laser source for emitting a laser beam (14),
- at least one optical module (20, 22) for modulating, converting and/or deflecting the laser beam (14), and
- a workpiece module (26) for receiving and supporting a workpiece to be produced and/or processed.

3. System (1) as claimed in claim 1 or 2, wherein the modular support (30) and the modules (18) are configured in such a way that the modules (18) for attachment on the module support (30) can be inserted along a common mounting direction (48) at mounting positions (68) of the module support (30) in such a way that the adjustment surface (66) comes into abutment with the reference surface (44).

4. System (1) as claimed in one of the previous claims, wherein for each module a fastening device (70) is provided, which comprises a first fastening means (72) on the module support plate (62) and a second fastening means (74) on the module support (30), wherein the fastening device (70) is configured in such a way that the module support plate (62) is pushed against an abutment surface (46) of the module support (30) and/or against the reference surface (44) with a maximum force defined by the construction of the fastening device (70) .

5. System (1) as claimed in claim 2, wherein the modules (18) are arranged in such a way that starting from the laser source a beam path (16) for the laser beam (14) is defined, which extends at first between the bottom support plate (32) and the top support plate (34), then is deflected above the top support plate (34) by a deflecting device arranged at an edge portion of bottom support plate (32) and then extends above the top support plate (34) along the longitudinal direction (38) .

6. System as claimed in one of the previous claims, wherein the module support plate (62) comprises a bottom face (86) for abutment on a support surface (46) of the module support and a top face (84) for arranging optical and/or mechanical functional elements (64), wherein in the top face (84) at least one recess (88) is provided into which an optical and/or mechanical functional element (64) of the respective module can be inserted with an exact fit.

7. Module support (30), configured for use in a system (1) as claimed in one of the previous claims, comprising a bottom support plate (32), a top support plate (34) and a spacer (36), wherein the spacer (36) is arranged between the bottom support plate (32) and the top support plate (34) and fixes these in a defined position with respect to each other,
wherein the bottom support plate (32) and the top support plate (34) each are configured in longitudinal extension along a longitudinal direction (38) and each comprise at least one reference surface (44) extending along the longitudinal direction (38).

8. Module support (30) as claimed in claim 7, wherein the bottom support plate (32) and the top support plate (34) comprise plate-like flat basic shapes extending parallel to one another.

9. Module support (30) as claimed in one of claims 7 or 8, wherein the spacer (36) comprises a beam passage opening (50) opening up a beam path extending parallel to the longitudinal direction (38).

10. Module support (30) as claimed in one of claims 7 - 9, wherein the top support plate (34) comprises a beam passage (52) which opens up a beam path from the top to the bottom of the top support plate (34).

11. Module support (30) as claimed in one of claims 7 - 10, wherein two spacers (36) are provided which are arranged at different positions along the longitudinal direction (38) in such a way that an intermediate space (40) is defined between top and bottom support plate and the two spacers (36).

12. Module support (30) as claimed in one of claims 7 - 11, wherein the reference surface (44) extends continuously over the entire extension of the respective support plate (32, 34).

13. Module support (30) as claimed in one of claims 7 - 12, wherein the bottom support plate (32) and the top support plate (34) comprise plate-like flat basic shapes for each of which a plane of extension (42) is defined, wherein the respective reference surface (44) extends orthogonally to the plane of extension (42) of the respective support plate (32, 34) .

14. Module support (30) as claimed in one of claims 7 - 13, wherein the top of the bottom and the top support plate (32, 34) comprise a recess (54) open at the edge orthogonally to the longitudinal direction, the bottom face of which forms a support surface (46) for module support plates (62), wherein the recess (54) is limited by the reference surface (44) opposite to its open edge area.

15. Module support (30) as claimed in one of claims 7 - 14, wherein the top of the bottom and the top support plate (32, 34) comprises at least one groove (76) extending along the longitudinal direction (38) for receiving a fixing element (78) of a fastening device (70) for module support plates (63), preferably a groove (76) with an undercut.

## Revendications

1. Système (1) pour la construction d'un dispositif de lithographie laser, comprenant une pluralité de modules (18) avec des fonctions optiques et/ou mécaniques et un support de module (30), lequel est réalisé de telle sorte que pour la construction du dispositif de lithographie laser (10), les différents modules (18) peuvent être ajoutés au support de module (30) ;
dans lequel le support de module (30) présente une plaque de support inférieure (32) et une plaque de support supérieure (34) et un écarteur (36), dans lequel l'écarteur (36) est disposé entre la plaque de support inférieure (32) et la plaque de support supérieure (34) et celles-ci sont fixées dans une position définie l'une par rapport à l'autre,
dans lequel la plaque de support inférieure (32) et la plaque de support supérieure (34) sont réalisées de façon respectivement étendue de manière allongée le long d'une direction longitudinale (38) et présentent respectivement au moins une surface de référence (44) s'étendant le long de la direction longitudinale (38),
et dans lequel les modules (18) présentent respectivement une plaque de support de module (62) avec une surface d'ajustement (66), dans lequel pour l'ajout du module (18) au support de module (30), la surface d'ajustement (66) est placée sur la surface de référence (44).

2. Système (1) selon la revendication 1, dans lequel les modules (18) comprennent :
- un module laser (12) avec une source laser pour l'émission d'un faisceau laser (14),
- au moins un module optique (20, 22) pour la modulation, le façonnage et/ou la déviation du faisceau laser (14), et
- un module de pièce (26) pour la réception et la retenue d'une pièce à produire et/ou à usiner.

3. Système (1) selon la revendication 1 ou 2, dans lequel le support de module (30) et les modules (18) sont réalisés de telle sorte que les modules (18) à ajouter au support de module (30) peuvent être introduits le long d'une direction d'installation (48) commune en des points de montage (68) du support de module (30) de telle sorte que la surface d'ajustement (66) vient en appui sur la surface de référence (44) .

4. Système (1) selon l'une quelconque des revendications précédentes, dans lequel un dispositif de fixation (70), lequel comprend un premier moyen de fixation (72) sur la plaque de support de module (62) et un deuxième moyen de fixation (74) sur le support de module (30), est prévu pour chaque module, dans lequel le dispositif de fixation (70) est réalisé de telle sorte que la plaque de support de module (62) est pressée avec une force maximale fixée par la conception du dispositif de fixation (70) contre une surface d'appui (46) du support de module (30) et/ou contre la surface de référence (44) .

5. Système (1) selon la revendication 2, dans lequel les modules (18) sont disposés de telle sorte qu'un trajet optique (16) pour le faisceau laser (14) est défini à partir de la source laser, lequel s'étend tout d'abord entre la plaque de support inférieure (32) et la plaque de support supérieure (34), puis est dévié par l'intermédiaire d'un dispositif de déviation disposé sur une partie de bord de la plaque de support inférieure (32) vers au-dessus de la plaque de support supérieure (34), et s'étend ensuite au-dessus de la plaque de support supérieure (34) le long de la direction longitudinale (38) .

6. Système (1) selon l'une quelconque des revendications précédentes, dans lequel la plaque de support de module (62) présente une face inférieure (86) destinée à être en appui sur une surface d'appui (46) du support de module et une face supérieure (84) pour la disposition d'éléments fonctionnels optiques et/ou mécaniques (64), dans lequel au moins un évidement (88) est prévu sur la face supérieure (84), dans lequel un élément fonctionnel optique et/ou mécanique (64) du module respectif peut être inséré de façon précisément ajustée.

7. Support de module (30) réalisé pour être utilisé dans un système (1) selon l'une quelconque des revendications précédentes, présentant une plaque de support inférieure (32), une plaque de support supérieure (34) et un écarteur (36), dans lequel l'écarteur (36) est disposé entre la plaque de support inférieure (32) et la plaque de support supérieure (34) et celles-ci sont fixées dans une position définie l'une par rapport à l'autre,
dans lequel la plaque de support inférieure (32) et la plaque de support supérieure (34) sont réalisées de façon respectivement étendue de manière allongée le long d'une direction longitudinale (38) et présentent respectivement au moins une surface de référence (44) s'étendant le long de la direction longitudinale (38),

8. Support de module (30) selon la revendication 7, dans lequel la plaque de support inférieure (32) et la plaque de support supérieure (34) présentent des formes de base plates du type plaque, qui s'étendent parallèlement les unes aux autres.

9. Support de module (30) selon l'une quelconque des revendications 7 ou 8, dans lequel l'écarteur (36) présente un trou de passage de faisceau (50), lequel libère un chemin de faisceau s'étendant parallèlement à la direction longitudinale (38) .

10. Support de module (30) selon l'une quelconque des revendications 7-9, dans lequel la plaque de support supérieure (34) présente un passage de faisceau (52), lequel libère un chemin de faisceau d'une face supérieure à une face inférieure de la plaque de support supérieure (34).

11. Support de module (30) selon l'une quelconque des revendications 7-10, dans lequel deux écarteurs (36) sont prévus, lesquels sont disposés en différentes positions le long de la direction longitudinale (38), de telle sorte qu'un espace intermédiaire (40) entre les plaques de support inférieure et supérieure et les deux écarteurs (36) est délimité.

12. Support de module (30) selon l'une quelconque des revendications 7-11, dans lequel la surface de référence (44) s'étend de manière continue sur toute l'étendue de la plaque de support (32, 34) respective.

13. Support de module (30) selon l'une quelconque des revendications 7-12, dans lequel la plaque de support inférieure (32) et la plaque de support supérieure (34) présentent des formes de base plates du type plaque, pour lesquelles respectivement un plan d'extension (42) est défini, dans lequel la surface de référence (44) respective s'étend perpendiculairement au plan d'extension (42) de la plaque de support (32, 34) respective.

14. Support de module (30) selon l'une quelconque des revendications 7-13, dans lequel la face supérieure de la plaque de support inférieure et de la plaque de support supérieure (32, 34) présente un évidement (54) ouvert sur un bord perpendiculairement à la direction longitudinale, dont la surface de fond forme une surface d'appui (46) pour des plaques de support de module (62), dans lequel l'évidement (54) est délimité de manière opposée à sa zone ouverte sur un bord par la surface de référence (44).

15. Support de module (30) selon l'une quelconque des revendications 7-14, dans lequel la face supérieure de la plaque de support inférieure et de la plaque de support supérieure (32, 34) présente au moins une rainure (76) s'étendant le long de la direction longitudinale (38) pour la réception d'un élément de retenue (78) d'un dispositif de fixation (70) pour des plaques de support de module (62), de préférence une rainure (76) avec dégagement.
